(19) Europäisches Patentamt
European Patent Office
Office européen des brevets

(11) **EP 3 537 443 A1**

(12) **DEMANDE DE BREVET EUROPEEN**

(43) Date de publication:
**11.09.2019 Bulletin 2019/37**

(51) Int Cl.:
***G11C 11/56*** (2006.01)

(21) Numéro de dépôt: **19161712.5**

(22) Date de dépôt: **08.03.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **09.03.2018 FR 1852039**

(71) Demandeur: **Commissariat à l'Energie Atomique et aux Energies Alternatives
75015 Paris (FR)**

(72) Inventeurs:
• **LA BARBERA, Selina**
**38054 GRENOBLE CEDEX 09 (FR)**
• **CASTELLANI, Niccolo**
**38054 GRENOBLE CEDEX 09 (FR)**
• **NAVARRO, Gabriele**
**38054 GRENOBLE CEDEX 09 (FR)**
• **VIANELLO, Elisa**
**38054 GRENOBLE CEDEX 09 (FR)**

(74) Mandataire: **Cabinet Camus Lebkiri
25 rue de Maubeuge
75009 Paris (FR)**

(54) **PROCÉDÉ DE PROGRAMMATION ANALOGIQUE D'UNE CELLULE MÉMOIRE À CHANGEMENT DE PHASE AU MOYEN D'IMPULSIONS ÉLECTRIQUES IDENTIQUES**

(57)    La présente invention se rapporte à un procédé de programmation (100) d'une cellule mémoire à changement de phase placée dans un état initial cristallin, la cellule mémoire étant apte à prendre une pluralité de valeurs de résistance appartenant à une plage de valeurs dite « fenêtre de programmation », le procédé étant caractérisé en ce qu'il comporte les étapes suivantes :
- (120) paramétrer une borne inférieure ($R_1$) de la fenêtre de programmation en appliquant à la cellule mémoire une unique impulsion de tension d'écriture graduelle ou une première série d'impulsions de tension d'écriture graduelle identiques ;
- (130) régler progressivement la valeur de résistance de la cellule mémoire au moyen des opérations suivantes :
∘ une opération d'effacement graduel (131) au cours de laquelle une série d'impulsions de tension d'effacement graduel identiques est appliquée à la cellule mémoire, les impulsions de tension d'effacement graduel étant définies de manière à entraîner une augmentation progressive de la valeur de résistance de la cellule mémoire ;
∘ une opération d'écriture graduelle (132) au cours de laquelle une deuxième série d'impulsions de tension d'écriture graduelle identiques est appliquée à la cellule mémoire, les impulsions de tension d'écriture graduelle étant définies de manière à entraîner une diminution progressive de la valeur de résistance de la cellule mémoire

les impulsions de tension d'écriture graduelle et d'effacement graduel présentant une largeur inférieure à 50 ns.

Fig. 1

**Description**

**DOMAINE TECHNIQUE DE L'INVENTION**

La présente invention concerne un procédé de programmation d'une cellule mémoire à changement de phase, également appelée PCM pour « Phase-Change Memory » selon la terminologie anglo-saxonne.

**ARRIÈRE-PLAN TECHNOLOGIQUE DE L'INVENTION**

Une cellule mémoire à changement de phase est un dispositif électronique comprenant un matériau à changement de phase disposé entre deux électrodes. Le matériau à changement de phase peut passer de manière réversible d'une phase amorphe, caractérisée par une résistivité électrique élevée, à une phase cristalline, caractérisée par une résistivité électrique faible. La résistance globale d'une telle cellule mémoire dépend donc de la proportion de chacune des phases au sein du matériau à changement de phase. Le passage de l'état amorphe à l'état cristallin, et inversement, s'effectue en appliquant à la cellule mémoire des impulsions électriques adaptées pour chaque transition d'un état à l'autre.

Les performances des cellules mémoires à changement de phase du point de vue de la capacité d'intégration, de l'endurance et de la consommation électrique font d'elles des candidates prometteuses pour réaliser des synapses artificielles destinées à connecter des neurones artificiels entre eux. Il est ainsi possible de réaliser un réseau de neurones artificiels s'inspirant du fonctionnement du cerveau humain. Après une phase d'apprentissage au cours de laquelle les connexions synaptiques entre les neurones sont créées et modifiées selon une règle d'apprentissage, le réseau de neurones peut être utilisé pour la détection et la classification d'objets et de motifs.

Une règle d'apprentissage classiquement utilisée par les réseaux de neurones est la règle dite de « plasticité fonction du temps d'occurrence des impulsions » (STDP pour « Spike-Timing Dépendent Plasticity » selon la terminologie anglo-saxonne). Il s'agit d'une règle d'inspiration biologique dont l'objectif est de reproduire les mécanismes d'apprentissage et de mémorisation des neurones et des synapses biologiques.

De manière générale, la plasticité synaptique est la capacité des synapses à modifier leur force en fonction de l'usage qui en est fait. La plasticité synaptique est basée sur deux phénomènes, à savoir la potentialisation à long terme (LTP pour « Long Term Potentiation » selon la terminologie anglo-saxonne) qui correspond à une augmentation de la force synaptique, et la dépression à long terme (LTD pour « Long Term Depression » selon la terminologie anglo-saxonne) qui correspond à une diminution de la force synaptique.

Pour mettre en oeuvre la règle STDP, il est nécessaire que la résistance des cellules mémoires qui modélisent les synapses artificielles du réseau de neurones puisse varier de façon progressive, aussi bien dans le sens de l'augmentation pour simuler la dépression à long terme que dans le sens de la diminution pour simuler la potentialisation à long terme. Pour ce faire, plusieurs méthodes sont connues dans l'antérieur.

Le document KUZUM D. et al., "Nanoelectronic Programmable Synapses Based on Phase Change Materials for Brain-Inspired Computing", Nano Letters 2012, 12 (5), pages 2179-2186, propose une première méthode consistant à adapter l'amplitude des impulsions appliquées à la cellule mémoire en fonction du changement d'état souhaité. L'augmentation progressive de la résistance de la cellule mémoire est par exemple obtenue en utilisant des impulsions dont l'amplitude augmente après chaque impulsion. Quant à la diminution progressive de la résistance de la cellule mémoire, elle peut être obtenue en utilisant des impulsions en forme de marches d'escalier, chaque marche correspondant à une valeur d'amplitude pour laquelle les impulsions sont répétées un certain nombre fois. Un inconvénient de cette méthode est que sa mise en oeuvre est complexe du point de vue de la programmation des impulsions.

Le document SURI M. et al., "Phase Change Memory as Synapse for Ultra-Dense Neuromorphic Systems: Application to Complex Visual Pattern Extraction", IEEE International Electron Devices Meeting, IEDM 2011, pages 4.4.1-4.4.4, propose une deuxième méthode sous la forme d'une solution circuit consistant à utiliser deux cellules mémoire à changement de phase identiques pour former une seule synapse. Cette méthode s'appuie sur le fait qu'une cristallisation progressive du matériau à changement de phase peut être obtenue en appliquant à la cellule mémoire des impulsions identiques. Ainsi, en montant une première cellule en direct et la deuxième cellule en inverse, les effets de la potentialisation à long terme peuvent être reproduits par la cristallisation progressive de la première cellule mémoire et les effets de la dépression à long terme peuvent être reproduits par la cristallisation progressive de la deuxième cellule mémoire. Dans ce cas, la programmation des impulsions s'en trouve simplifiée. Cependant, un inconvénient de cette méthode est qu'elle nécessite des opérations de rafraîchissement de l'état des cellules mémoires qui sont à la fois longues et coûteuses du point de vue de la consommation électrique. De plus, cette méthode double le nombre de cellules mémoires nécessaires pour former les synapses du réseau de neurones, ce qui réduit la capacité d'intégration.

**EP 3 537 443 A1**

## RÉSUMÉ DE L'INVENTION

Il ressort de ce qui précède qu'il existe un besoin d'améliorer la programmation d'une cellule mémoire à changement de phase afin qu'elle change d'état de manière progressive, notamment dans le but d'utiliser la cellule mémoire comme synapse artificielle dans un réseau de neurones artificiels.

La présente invention vise à répondre à ce besoin en proposant un procédé de programmation d'une cellule mémoire à changement de phase placée dans un état initial cristallin, la cellule mémoire étant apte à prendre une pluralité de valeurs de résistance appartenant à une plage de valeurs dite « fenêtre de programmation », le procédé comportant les étapes suivantes :

- paramétrer une borne inférieure de la fenêtre de programmation en appliquant à la cellule mémoire une unique impulsion de tension d'écriture graduelle ou une première série d'impulsions de tension d'écriture graduelle identiques ;
- régler progressivement la valeur de résistance de la cellule mémoire au moyen des opérations suivantes :

  ◦ une opération d'effacement graduel au cours de laquelle une série d'impulsions de tension d'effacement graduel identiques est appliquée à la cellule mémoire, les impulsions de tension d'effacement graduel étant définies de manière à entraîner une augmentation progressive de la valeur de résistance de la cellule mémoire ;
  ◦ une opération d'écriture graduelle au cours de laquelle une deuxième série d'impulsions de tension d'écriture graduelle identiques est appliquée à la cellule mémoire, les impulsions de tension d'écriture graduelle étant définies de manière à entraîner une diminution progressive de la valeur de résistance de la cellule mémoire

les impulsions de tension d'écriture graduelle et d'effacement graduel présentant une largeur inférieure à 50 ns.

La présente invention permet de programmer, c'est-à-dire de modifier la résistance de la cellule mémoire à changement de phase, au moyen d'impulsions électriques identiques. La programmation de la cellule mémoire s'en trouve ainsi simplifiée. Dans le contexte de l'invention, les impulsions de tensions sont définies par des paramètres caractéristiques tels que la cellule mémoire est traversé par un courant électrique appartenant à un régime non stationnaire ce qui permet au matériau à changement de phase de la cellule mémoire de passer progressivement d'un état cristallin à un état amorphe, et réciproquement. Dans le régime non stationnaire, le courant électrique traversant la cellule mémoire n'a pas le temps d'atteindre sa valeur maximale.

Le procédé selon l'invention peut également comporter une ou plusieurs caractéristiques parmi les suivantes considérées individuellement ou selon toutes les combinaisons techniquement possibles.

Selon un mode de mise en oeuvre, la cellule mémoire est placée dans l'état initial cristallin au cours d'une étape d'initialisation, les impulsions de tension d'écriture graduelle et d'effacement graduel étant définies par une amplitude et une largeur déterminées au cours de l'étape d'initialisation.

Selon un mode de mise en oeuvre, la cellule mémoire atteint un état entièrement effacé au cours de l'étape d'initialisation lorsque des impulsions de tension ayant une amplitude dite « d'effacement total » sont appliquées à la cellule mémoire, les impulsions de tension d'écriture graduelle et d'effacement graduel présentant chacune une amplitude inférieure à l'amplitude d'effacement total.

Selon un mode de mise en oeuvre, l'amplitude des impulsions de tension d'écriture graduelle satisfait à la relation suivante :

$$V_{melt} + \frac{5}{100}\left(V_{RESET\_tot} - V_{melt}\right) \leq V_{SET\_grad} \leq V_{melt} + \frac{30}{100}\left(V_{RESET\_tot} - V_{melt}\right)$$

où $V_{melt}$ est une tension de début d'amorphisation et $V_{RESET\_tot}$ est l'amplitude d'effacement total.

Selon un mode de mise en oeuvre, l'amplitude des impulsions de tension d'effacement graduel satisfait à la relation suivante :

$$V_{melt} + \frac{60}{100}\left(V_{RESET\_tot} - V_{melt}\right) \leq V_{RESET\_grad} \leq V_{melt} + \frac{80}{100}\left(V_{RESET\_tot} - V_{melt}\right)$$

où $V_{melt}$ est une tension de début d'amorphisation et $V_{RESET\_tot}$ est l'amplitude d'effacement total.

Selon un mode de mise en oeuvre, la borne inférieure de la fenêtre de programmation est comprise entre 15 kΩ et 30 kΩ.

3

Selon un mode de mise en oeuvre, la cellule mémoire comporte un matériau à changement de phase à base d'un chalcogénure ou d'un alliage de chalcogénures.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1 est un diagramme fonctionnel d'un mode de mise en oeuvre du procédé selon l'invention ;
- la figure 2 représente une courbe caractéristique de la résistance en fonction de l'amplitude des impulsions de tension appliquées à une cellule mémoire ;
- la figure 3 représente des courbes caractéristiques de la résistance en fonction de l'amplitude des impulsions de tension appliquées à la cellule mémoire de la figure 2, pour différentes largeurs ou durées d'impulsions ;
- la figure 4 représente une courbe de variation de la résistance en fonction de l'amplitude et du nombre des impulsions de tension appliquées à la cellule mémoire de la figure 2 ; et
- la figure 5 représente les courbes de variation de la résistance en fonction de l'amplitude et du nombre des impulsions de tension appliquées à la cellule mémoire de la figure 2, pour trois séquences d'impulsions différentes.

Les figures ne sont présentées qu'à titre indicatif et nullement limitatif de l'invention.

Pour plus de clarté, les éléments identiques ou similaires sont repérés par des signes de référence identiques sur toutes les figures.

## DESCRIPTION DÉTAILLÉE DE MODES DE MISE EN ŒUVRE DE L'INVENTION

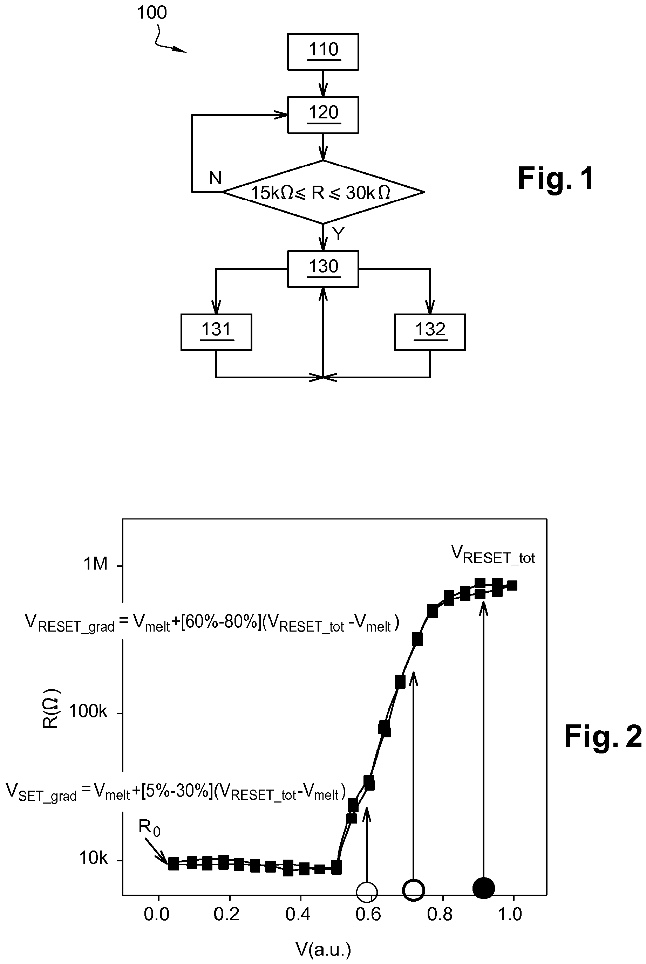

La figure 1 montre un procédé de programmation 100 d'une cellule mémoire à changement de phase, selon un mode de mise en oeuvre l'invention. Une cellule mémoire à changement de phase est un dispositif électronique comprenant un matériau à changement de phase disposé entre une électrode inférieure et une électrode supérieure.

La cellule mémoire présente une résistance électrique qui dépend de l'état dans lequel se trouve le matériau à changement de phase. En effet, le matériau à changement de phase est capable de basculer de manière réversible entre un état amorphe caractérisé par une résistivité électrique élevée et un état cristallin caractérisé par une résistivité électrique faible. Par conséquent, la résistance de la cellule mémoire est fonction du degré de cristallisation du matériau à changement de phase. Autrement dit, plus le matériau à changement de phase présente une zone cristallisée importante, plus la résistance de la cellule mémoire est faible. Réciproquement, plus le matériau à changement de phase présente une zone amorphe importante, plus la résistance de la cellule mémoire est élevée.

Le matériau à changement de phase passe de l'état amorphe à l'état cristallin, et inversement, lorsque des impulsions électriques, par exemple de forme rectangulaire, sont appliquées à la cellule mémoire. Le matériau à changement de phase est préférentiellement un matériau à base d'un chalcogénure ou d'un alliage de chalcogénures tel que du $Ge_2Sb_2Te_5$ (GST) ou du GeTe. Cependant, le matériau à changement de phase peut être tout matériau capable de changer de phase réversiblement au moyen d'un courant électrique passant entre les deux électrodes.

Dans l'ensemble de la description et dans les revendications, les impulsions de tension définies de manière à permettre au matériau à changement de phase de passer progressivement de l'état amorphe à l'état cristallin sont appelées « impulsions de tension d'écriture graduelle » et les impulsions de tension définies de manière à permettre au matériau à changement de phase de passer progressivement de l'état cristallin à l'état amorphe sont appelées « impulsions de tension d'effacement graduel ».

En fonctionnement, l'ensemble des valeurs de résistance que peut prendre la cellule mémoire définit une fenêtre de programmation. Il s'agit d'une plage de valeurs comprenant une borne inférieure et une borne supérieure entre lesquelles s'étendent une multitude de valeurs de résistance intermédiaires qui correspondent à différentes proportions des phases amorphe et cristalline du matériau à changement de phase. En d'autres termes, la cellule mémoire peut prendre n'importe quelle valeur de résistance située dans la fenêtre de programmation.

Le procédé de programmation 100 comporte une étape de paramétrage 120 de la borne inférieure $R_1$ de la fenêtre de programmation. Pour ce faire, une unique impulsion de tension d'écriture graduelle (ou partielle) peut être appliquée à la cellule mémoire de manière à former une zone amorphe de faible étendue dans le matériau à changement de phase. Selon la résistance initiale de la cellule mémoire, la borne inférieure $R_1$ de la fenêtre de programmation peut être paramétrée en appliquant une première série d'impulsions de tension d'écriture graduelle (ou partielle) identiques. La première série d'impulsions comporte un nombre d'impulsions adapté pour atteindre la valeur de résistance $R_1$. Ce nombre dépend notamment de l'amplitude des impulsions et de la structure de la cellule mémoire. De préférence, la borne inférieure $R_1$ de la fenêtre de programmation est comprise entre 15 kΩ et 30 kΩ. Dans ce cas, la zone amorphe ainsi créée couvre une partie seulement de la surface de contact entre le matériau à changement de phase et l'électrode inférieure de la cellule mémoire.

Dans l'ensemble de la description et dans les revendications, on entend par « impulsions identiques » des impulsions délivrées par une même source d'alimentation qui est configurée de la même manière pour chaque impulsion, ces impulsions étant donc supposées être identiques, ou à tout le moins similaires, du point de vue de leurs paramètres caractéristiques tels que leur amplitude et leur largeur (i.e. durée).

Dans un mode de mise en oeuvre de l'étape de paramétrage 120, l'amorphisation partielle du matériau à changement de phase est obtenue en appliquant à la cellule mémoire une impulsion unique ayant une amplitude qui décroit de façon continue (autrement dit une impulsion en forme de rampe continue) ou une série d'impulsions d'amplitude décroissante. Le matériau à changement de phase est ainsi amorphisé entièrement puis recristallisé partiellement. Dans une variante de mise en oeuvre, une série d'impulsions d'amplitude croissante est appliquée à partir d'un état entièrement cristallisé, ce qui permet d'amorphiser graduellement le matériau jusqu'à obtenir la résistance $R_1$ souhaitée.

La borne supérieure $R_{MAX}$ de la fenêtre de programmation correspond à la valeur maximale que peut prendre la résistance de la cellule mémoire avec une commutation analogique, c'est-à-dire un passage progressif d'un état à l'autre.

L'étape de paramétrage 120 est avantageusement effectuée lorsque la cellule mémoire est dans un état initial cristallin. Cependant, après sa fabrication, la cellule mémoire est dans un état vierge. Dans cet état vierge, le matériau à changement de phase est dans un état inconnu qui dépend notamment du procédé de fabrication et des matériaux utilisés. Le degré de cristallisation n'est à priori pas connu. La cellule mémoire est donc avantageusement placée dans l'état initial cristallin avant l'étape de paramétrage 120 au cours d'une étape d'initialisation 110. Il est ainsi possible d'obtenir un état de référence connu. Dans l'état initial cristallin, la cellule mémoire présente une résistance minimale Ro, par exemple inférieure à 10 kΩ. L'état initial cristallin est par exemple atteint lorsque le matériau à changement de phase est entièrement cristallisé. Il résulte alors de l'étape de paramétrage 120 une augmentation de la résistance de la cellule mémoire jusqu'à atteindre la valeur de résistance $R_1$ (15-35 kΩ).

Après l'étape de paramétrage 120, le procédé de programmation 100 comporte une étape de réglage 130 progressif de la valeur de résistance de la cellule mémoire. Cette étape de réglage 130 comporte les deux opérations suivantes qui peuvent être réalisées successivement (c'est-à-dire l'une après l'autre) et dans n'importe quel ordre (enchaînement aléatoire).

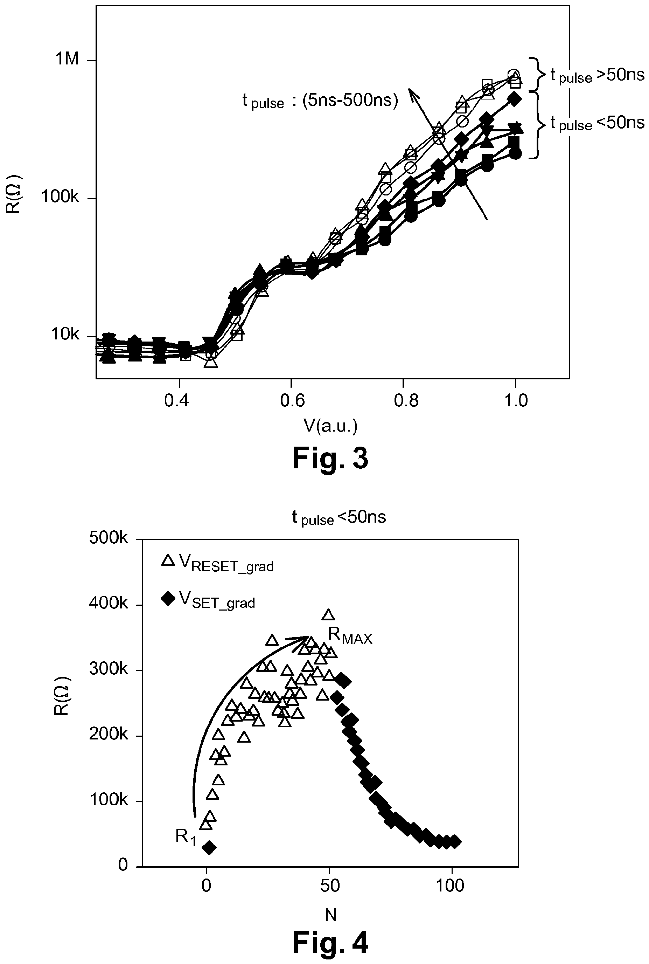

Une première opération 131 dite « opération d'effacement graduel » consiste à appliquer à la cellule mémoire une série d'impulsions de tension d'effacement graduel identiques. Sous l'effet de ces impulsions, le matériau à changement de phase voit son degré de cristallisation diminuer progressivement. Il en résulte une augmentation progressive de la résistance de la cellule mémoire. La résistance peut augmenter jusqu'à atteindre la borne supérieure $R_{MAX}$ de la fenêtre de programmation si le nombre d'impulsions de tension d'effacement graduel est suffisamment grand (cf. Fig.4).

Inversement, une deuxième opération 132 dite « opération d'écriture graduelle » consiste à appliquer à la cellule mémoire une deuxième série d'impulsions de tension d'écriture graduelle identiques. Sous l'effet de ces impulsions, le matériau à changement voit son degré de cristallisation augmenter progressivement. Il en résulte une diminution progressive de la résistance de la cellule mémoire. La résistance peut diminuer jusqu'à atteindre la borne inférieure $R_1$ de la fenêtre de programmation si le nombre d'impulsions de tension d'écriture graduelle est suffisamment grand (cf. Fig.4).

L'étape d'initialisation 110 est de préférence effectuée en appliquant à la cellule mémoire des impulsions de tension ayant une forme rectangulaire et une amplitude qui augmente puis diminue, par exemple après chaque impulsion, avec un pas prédéterminé. Une telle programmation des impulsions est dite « en forme de marches d'escalier » (« staircase programming » selon la terminologie anglo-saxonne), en référence à la forme des impulsions.

Les impulsions de tension d'effacement graduel et d'écriture graduelle qui sont appliquées à la cellule mémoire présentent des paramètres caractéristiques (durée, amplitude) tels que l'état du matériau à changement de phase est modifié de manière progressive. Avantageusement, les paramètres caractéristiques de ces impulsions de tension sont définis au cours de l'étape d'initialisation 110. Cette détermination n'a besoin d'être accomplie qu'une seule fois pour caractériser l'empilement de la cellule mémoire à changement de phase. Une fois déterminés les paramètres caractéristiques des impulsions de tension d'effacement graduel et d'écriture graduelle pour un empilement, toutes les cellules mémoire comprenant ce même empilement peuvent être programmées au moyen des étapes 120 et 130 uniquement. La largeur des impulsions de tension d'écriture graduelle est de préférence égale à la largeur des impulsions de tension d'effacement graduel.

La figure 2 montre un exemple de courbe caractéristique de la résistance de la cellule mémoire en fonction de l'amplitude des impulsions de tension appliquées à la cellule mémoire, dans le cas d'une programmation en forme de marches d'escalier telle que décrite précédemment. Dans cet exemple, les impulsions ont une largeur de 500 ns et une amplitude qui augmente puis diminue. La taille de la zone amorphe, et par conséquent la valeur de résistance R, augmente avec l'amplitude V des impulsions jusqu'à atteindre l'état entièrement effacé pour une amplitude d'effacement total $V_{RESET\_tot}$ puis diminue jusqu'à atteindre l'état entièrement cristallisé ($R_0$).

A partir de la courbe de la figure 2, il est possible de définir l'amplitude des impulsions de tension à appliquer à la cellule mémoire pour modifier progressivement la valeur de résistance à l'étape de réglage 130. Avantageusement, l'amplitude des impulsions de tension est inférieure à l'amplitude d'effacement total $V_{RESET\_tot}$ de manière à limiter la densité de courant électrique traversant la cellule mémoire, et donc la température, afin de provoquer une modification progressive de l'état du matériau à changement de phase.

De préférence, les impulsions de tension d'écriture graduelle présentent une amplitude d'écriture graduelle $V_{SET\_grad}$ telle que :

$$V_{melt} + \frac{5}{100}\left(V_{RESET\_tot} - V_{melt}\right) \leq V_{SET\_grad} \leq V_{melt} + \frac{30}{100}\left(V_{RESET\_tot} - V_{melt}\right)$$

où $V_{melt}$ est une tension de début d'amorphisation, c'est-à-dire la tension à partir de laquelle on commence à amorphiser le matériau à changement de phase, et $V_{RESET\_tot}$ est l'amplitude d'effacement total. La tension de début d'amorphisation $V_{melt}$ peut être déterminée à partir de l'étape 120 (Fig.2). Il s'agit de la tension à laquelle on commence à voir une augmentation de la résistance.

Si on considère une tension de début d'amorphisation $V_{melt}$ nulle, alors l'amplitude $V_{SET\_grad}$ des impulsions de tension d'écriture graduelle est comprise entre 5 % et 30 % de l'amplitude d'effacement total $V_{RESET\_tot}$.

De préférence, les impulsions de tension d'effacement graduel présentent une amplitude d'effacement graduel $V_{RESET\_grad}$ telle que :

$$V_{melt} + \frac{60}{100}\left(V_{RESET\_tot} - V_{melt}\right) \leq V_{RESET\_grad} \leq V_{melt} + \frac{80}{100}\left(V_{RESET\_tot} - V_{melt}\right)$$

Si on considère une tension de début d'amorphisation $V_{melt}$ nulle, alors l'amplitude $V_{RESET\_grad}$ des impulsions de tension d'effacement graduel est comprise entre 60 % et 80 % de l'amplitude d'effacement total $V_{RESET\_tot}$.

Dans l'exemple de la figure 2, la tension de début d'amorphisation $V_{melt}$ est environ égale à 0.5 a.u. (« arbitrary unit » en anglais) et l'amplitude d'effacement total $V_{RESET\_tot}$ est environ égale à 0.9 a.u. L'amplitude d'écriture graduelle VsET_grad est alors comprise entre 0.52 a.u. et 0.62 a.u. environ et l'amplitude d'effacement graduel $V_{RESET\_grad}$ est alors comprise entre 0.74 a.u. et 0.82 a.u. environ.

La figure 3 montre l'influence de la largeur ou durée $t_{pulse}$ des impulsions de tension sur le passage de l'état cristallin à l'état amorphe du matériau à changement de phase avec une programmation en forme de marches d'escalier de la cellule mémoire. Dans cet exemple, lorsque la largeur $t_{pulse}$ des impulsions de tension est supérieure à 50 ns, le courant traversant la cellule mémoire est dans un régime stationnaire et la résistance de la cellule mémoire est indépendante de la largeur $t_{pulse}$ des impulsions. Par contre, lorsque la largeur $t_{pulse}$ des impulsions est inférieure à 50 ns, le courant n'a pas le temps d'atteindre le régime stationnaire et la résistance de la cellule mémoire dépend de la largeur $t_{pulse}$ des impulsions. Par conséquent, la largeur des impulsions de tension d'écriture graduelle et d'effacement graduel est avantageusement inférieure à 50 ns afin de rendre possible les modifications progressives de l'état du matériau à changement de phase. La variation de résistance de la cellule mémoire à chaque impulsion de tension d'écriture graduelle ou d'effacement graduel dépend de la largeur des impulsions.

Grâce à l'invention, la résistance de la cellule mémoire peut être ajustée de manière progressive en utilisant des impulsions identiques ce qui simplifie la programmation. Le matériau à changement de phase peut avoir différents stades de cristallisation correspondant chacun à une valeur de résistance. Le passage de l'état amorphe à l'état cristallin, et inversement, s'effectue donc de manière analogique tel qu'illustré à la figure 4, par opposition à un comportement binaire se traduisant seulement par un état amorphe fortement résistif et un état cristallin faiblement résistif. La résistance de la cellule mémoire tend vers la borne inférieure $R_1$ en appliquant les impulsions d'amplitude $V_{SET\_grad}$ et tend vers la borne supérieure $R_{max}$ en appliquant les impulsions d'amplitude $V_{RESET\_grad}$.

Un tel comportement analogique peut permettre de mettre en oeuvre une phase d'apprentissage non-supervisé, également appelée « on-line learning » selon la terminologie anglo-saxonne, en utilisant la cellule mémoire à changement de phase en tant que synapse dans un réseau de neurones artificiels. Lors d'une phase d'apprentissage non-supervisé, chaque résistance synaptique est déterminée in situ, ce qui permet de modéliser la potentialisation à long terme (LTP) et la dépression à long terme (LTD).

Il est à noter que le comportement binaire peut être obtenu lorsque le courant électrique traversant la cellule mémoire se trouve dans un régime stationnaire, c'est-à-dire lorsque la largeur des impulsions de tension est par exemple supérieure à 50 ns.

Dans un mode de mise en oeuvre préférentiel du procédé de programmation, l'impulsion de tension (ou la série d'impulsions de tension identiques) appliquée à l'étape de paramétrage 120 présente une amplitude égale à l'amplitude d'écriture graduelle $V_{SET\_grad}$ (appliquée lors de la deuxième opération 132). Seules deux amplitudes,

$V_{SET\_grad}$ et $V_{RESET\_grad}$, sont alors utilisées, ce qui simplifie encore plus la programmation de la cellule mémoire.

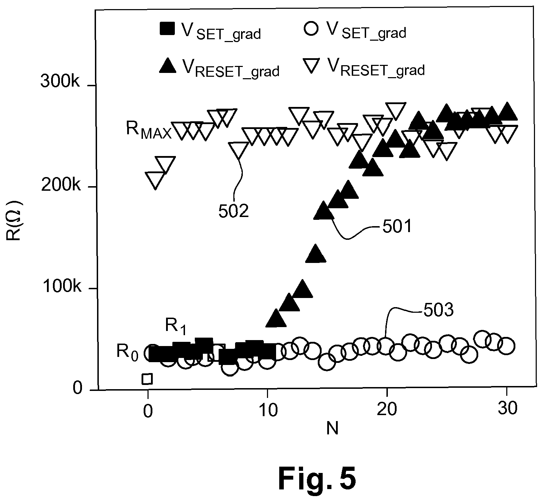

La figure 5 illustre la comparaison entre trois séquences d'impulsions utilisées pour programmer la cellule mémoire. Une première séquence 501 appliquée à la cellule mémoire est une séquence selon l'invention et comprend 10 impulsions d'écriture graduelle identiques ($V = V_{SET\_grad}$) suivies de 20 impulsions d'effacement graduel identiques ($V = V_{RESET\_grad}$). Il est ainsi possible d'observer l'augmentation progressive de la résistance de la cellule mémoire, d'abord de la résistance initiale $R_0$ à la borne inférieure $R_1$ de la fenêtre de programmation, puis de la borne inférieure $R_1$ à la borne supérieure $R_{max}$ de la fenêtre de programmation. Au contraire, lorsqu'une deuxième séquence 502 comprenant uniquement des impulsions d'effacement graduel ($V = V_{RESET\_grad}$), en l'occurrence au nombre de 30, est appliquée à la cellule mémoire, il est possible d'observer un passage abrupte de l'état initial cristallin ($R_0$) à l'état amorphe ($R_{Max}$). Lorsqu'une troisième séquence 503 comprenant uniquement des impulsions d'écriture graduelle ($V_{SET\_grad}$), en l'occurrence au nombre de 30, est appliquée à la cellule mémoire, l'amplitude d'écriture graduelle $V_{SET\_grad}$ n'est pas suffisante pour induire un changement d'état de résistance au-delà de la borne inférieure $R_1$ de la fenêtre de programmation.

Dans la cellule mémoire des figures 2 à 5, le matériau à changement de phase est un alliage de chalcogénures ayant pour formule $Ge_2Sb_2Te_5$ (GST) et présente une épaisseur de 50 nm.

Naturellement, l'invention n'est pas limitée aux modes de mise en oeuvre décrits en référence aux figures et des variantes pourraient être envisagées sans sortir du cadre de l'invention.

**Revendications**

1. Procédé de programmation (100) d'une cellule mémoire à changement de phase placée dans un état initial cristallin, la cellule mémoire étant apte à prendre une pluralité de valeurs de résistance appartenant à une plage de valeurs dite « fenêtre de programmation », le procédé étant **caractérisé en ce qu'**il comporte les étapes suivantes :

   - (120) paramétrer une borne inférieure ($R_1$) de la fenêtre de programmation en appliquant à la cellule mémoire une unique impulsion de tension d'écriture graduelle ou une première série d'impulsions de tension d'écriture graduelle identiques ;
   - (130) régler progressivement la valeur de résistance de la cellule mémoire au moyen des opérations suivantes :

      ◦ une opération d'effacement graduel (131) au cours de laquelle une série d'impulsions de tension d'effacement graduel identiques est appliquée à la cellule mémoire, les impulsions de tension d'effacement graduel étant définies de manière à entraîner une augmentation progressive de la valeur de résistance de la cellule mémoire ;
      ◦ une opération d'écriture graduelle (132) au cours de laquelle une deuxième série d'impulsions de tension d'écriture graduelle identiques est appliquée à la cellule mémoire, les impulsions de tension d'écriture graduelle étant définies de manière à entraîner une diminution progressive de la valeur de résistance de la cellule mémoire ;

   les impulsions de tension d'écriture graduelle et d'effacement graduel présentant une largeur ($t_{pulse}$) inférieure à 50 ns.

2. Procédé de programmation (100) selon la revendication 1, **caractérisé en ce que** la cellule mémoire est placée dans l'état initial cristallin au cours d'une étape d'initialisation (110), les impulsions de tension d'écriture graduelle et d'effacement graduel étant définies par une amplitude et une largeur déterminées au cours de l'étape d'initialisation (110).

3. Procédé de programmation (100) selon la revendication 2, **caractérisé en ce que** la cellule mémoire atteint un état entièrement effacé au cours de l'étape d'initialisation (110) lorsque des impulsions de tension ayant une amplitude dite « d'effacement total » ($V_{RESET\_tot}$) sont appliquées à la cellule mémoire, les impulsions de tension d'écriture graduelle et d'effacement graduel présentant chacune une amplitude inférieure à l'amplitude d'effacement total ($V_{RESET\_tot}$).

4. Procédé de programmation (100) selon la revendication 3, **caractérisé en ce que** l'amplitude ($V_{SET\_grad}$) des impulsions de tension d'écriture graduelle satisfait à la relation suivante :

$$V_{melt} + \frac{5}{100}\left(V_{RESET\_tot} - V_{melt}\right) \leq V_{SET\_grad} \leq V_{melt} + \frac{30}{100}\left(V_{RESET\_tot} - V_{melt}\right)$$

où $V_{melt}$ est une tension de début d'amorphisation et $V_{RESET\_tot}$ est l'amplitude d'effacement total.

**5.** Procédé de programmation (100) selon l'une quelconque des revendications 3 et 4, **caractérisé en ce que** l'amplitude (VRESET_grad) des impulsions de tension d'effacement graduel satisfait à la relation suivante :

$$V_{melt} + \frac{60}{100}\left(V_{RESET\_tot} - V_{melt}\right) \leq V_{RESET\_grad} \leq V_{melt} + \frac{80}{100}\left(V_{RESET\_tot} - V_{melt}\right)$$

où $V_{melt}$ est une tension de début d'amorphisation et $V_{RESET\_tot}$ est l'amplitude d'effacement total.

**6.** Procédé de programmation (100) selon l'une quelconque des revendications 1 à 5, **caractérisé en ce que** la borne inférieure ($R_1$) de la fenêtre de programmation est comprise entre 15 k$\Omega$ et 30 k$\Omega$.

**7.** Procédé de programmation (100) selon l'une quelconque des revendications 1 à 6, **caractérisé en ce que** la cellule mémoire comporte un matériau à changement de phase à base d'un chalcogénure ou d'un alliage de chalcogénures.

Fig. 1

$$V_{RESET\_grad} = V_{melt} + [60\%\text{-}80\%](V_{RESET\_tot} - V_{melt})$$

$$V_{SET\_grad} = V_{melt} + [5\%\text{-}30\%](V_{RESET\_tot} - V_{melt})$$

Fig. 2

**Fig. 3**

**Fig. 4**

**Fig. 5**

**Europäisches Patentamt**
**European Patent Office**
**Office européen des brevets**

# RAPPORT DE RECHERCHE EUROPEENNE

Numéro de la demande

EP 19 16 1712

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2017/184853 A1 (NANTERO INC [US]) 26 octobre 2017 (2017-10-26) | 1,6,7 | INV. G11C11/56 |
| Y | * alinéas [0042] - [0096]; revendications 1-23; figures 4a-15c * ----- | 2-5 | |
| Y | US 2009/003035 A1 (PHILIPP JAN BORIS [US] ET AL) 1 janvier 2009 (2009-01-01) * alinéas [0024] - [0054]; figures 1-15 * ----- | 2-5 | |
| A | US 2006/166455 A1 (GORDON GEORGE [US] ET AL) 27 juillet 2006 (2006-07-27) * le document en entier * ----- | 2-5 | |
| A | WO 2013/000940 A1 (COMMISSARIAT ENERGIE ATOMIQUE [FR]; BICHLER OLIVIER [FR]; DESALVO BARB) 3 janvier 2013 (2013-01-03) * le document en entier * ----- | 1-7 | |

**DOMAINES TECHNIQUES RECHERCHES (IPC)**

G11C

Le présent rapport a été établi pour toutes les revendications

| Lieu de la recherche | Date d'achèvement de la recherche | Examinateur |
|---|---|---|
| La Haye | 11 juillet 2019 | Czarik, Damien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 19 16 1712

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-07-2019

| Document brevet cité au rapport de recherche | | Date de publication | Membre(s) de la famille de brevet(s) | | Date de publication |
|---|---|---|---|---|---|
| WO 2017184853 | A1 | 26-10-2017 | US 2017309334 A1<br>WO 2017184853 A1 | | 26-10-2017<br>26-10-2017 |
| US 2009003035 | A1 | 01-01-2009 | DE 102008030859 A1<br>US 2009003035 A1 | | 29-01-2009<br>01-01-2009 |
| US 2006166455 | A1 | 27-07-2006 | US 2006166455 A1<br>US 2007077699 A1 | | 27-07-2006<br>05-04-2007 |
| WO 2013000940 | A1 | 03-01-2013 | FR 2977350 A1<br>US 2014122402 A1<br>WO 2013000940 A1 | | 04-01-2013<br>01-05-2014<br>03-01-2013 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **KUZUM D. et al.** Nanoelectronic Programmable Synapses Based on Phase Change Materials for Brain-Inspired Computing. *Nano Letters,* 2012, vol. 12 (5), 2179-2186

- **SURI M. et al.** Phase Change Memory as Synapse for Ultra-Dense Neuromorphic Systems: Application to Complex Visual Pattern Extraction. *IEEE International Electron Devices Meeting, IEDM,* 2011, 4.4.1-4.4.4